(19) Europäisches Patentamt
European Patent Office
Office européen des brevets

(11) **EP 2 410 569 A1**

(12) **EUROPEAN PATENT APPLICATION**
published in accordance with Art. 153(4) EPC

(43) Date of publication:
**25.01.2012 Bulletin 2012/04**

(51) Int Cl.:
***H01L 31/0352*** *(2006.01)*

(21) Application number: **09841702.5**

(22) Date of filing: **17.03.2009**

(86) International application number:
**PCT/CN2009/070853**

(87) International publication number:
**WO 2010/105418 (23.09.2010 Gazette 2010/38)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**

(71) Applicant: **Shen, Kuo-Hung
Taiwan 325 (CN)**

(72) Inventor: **Shen, Kuo-Hung
Taiwan 325 (CN)**

(74) Representative: **Lang, Christian et al
LangRaible GbR
Patent- und Rechtsanwälte
Rosenheimerstrasse 139
81671 München (DE)**

(54) **THIN FILM SOLAR CELL STRUCTURE**

(57) A thin-film solar cell includes an optical conduction cylinder, a transparent electrically conducting layer evenly plated on an axially extending peripheral surface of the optical conduction cylinder, at least one middle reaction layer plated on a peripheral surface of the electrically conducting layer, and a reflective layer plated on a peripheral surface of the middle reaction layer. Thus, the reflective layer can reflect the sun light to prevent from permeation of the sun light so that the sun light is enveloped in the optical conduction cylinder completely and is reflected successively in the reflective layer until the solar energy is exhausted such that the thin-film solar cell can absorb the solar energy to the maximum extent to enhance the light enveloping effect largely and to enhance the generating efficiency of the thin-film solar cell.

FIG.4

**Description**

BACKGROUND OF THE INVENTION

1. Field of the Invention

The present invention relates to a solar cell and, more particularly, to a thin-film solar cell.

2. Description of the Related Art

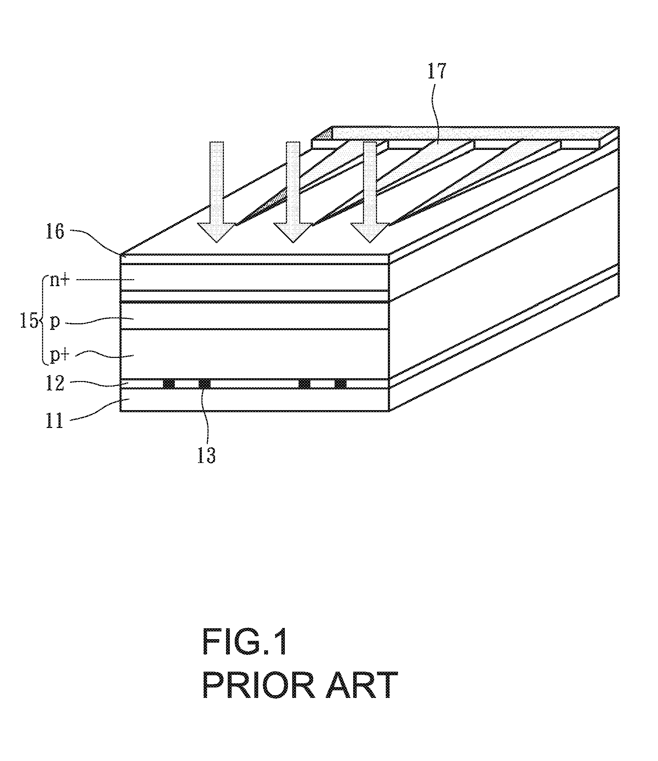

A conventional thin-film solar cell in accordance with the prior art shown in Fig. 1 comprises a substrate 11, a reflective layer 12 plated on a surface of the substrate 11 and having a surface provided with at least one inner electrode 13, at least one middle reaction layer 15 plated on a surface of the reflective layer 12, and a transparent electrically conducting layer 16 plated on a surface of the middle reaction layer 15 and having a surface provided with at least one outer electrode 17 which is connected serially with the inner electrode 13 of the reflective layer 12. The electrically conducting layer 16 has a Photovolatic effect. The middle reaction layer 15 includes at least one P+ semi-conductor layer plated on the reflective layer 12 to produce electric holes, at least one P semi-conductor layer plated on the P+ semi-conductor layer and at least one N+ semi-conductor layer plated on the P semi-conductor layer to produce electrons.

In operation, the middle reaction layer 55 can absorb the sun light when the sun light enters and passes through the middle reaction layer 15 so that when the P+ semi-conductor layer 551 and the N+ semi-conductor layer 553 of the middle reaction layer 55 are connected, an induction electrode is produced to drive the electrons and electric holes to shift by exciting of the sun light. Thus, the electrons are moved outward to reach the outer electrode 17 of the electrically conducting layer 16 to form an electronic flow in the outer electrode 17 of the electrically conducting layer 16, while the electric holes are moved inward to reach the inner electrode 13 of the reflective layer 12 to form an electric current in the inner electrode 13 of the reflective layer 12 so that the electronic flow is connected to the electric current to form a generating system. At this time, the P+ semi-conductor layer and the N+ semi-conductor layer of the middle reaction layer 15 produce an energy barrier to the electrons and electric holes so that the electrons and electric holes will not combine easily to prevent the electrons and electric holes from disappearing due to combination.

However, the conventional thin-film solar cell has a planar shape with a smaller illuminated area, thereby decreasing the generating efficiency of the conventional thin-film solar cell. In addition, the conventional thin-film solar cell cannot envelop the sun light completely, and the sun light is reflected by the reflective layer 12 to form an energy loss during the reflected process of the sun light, thereby decreasing the generating efficiency of the conventional thin-film solar cell.

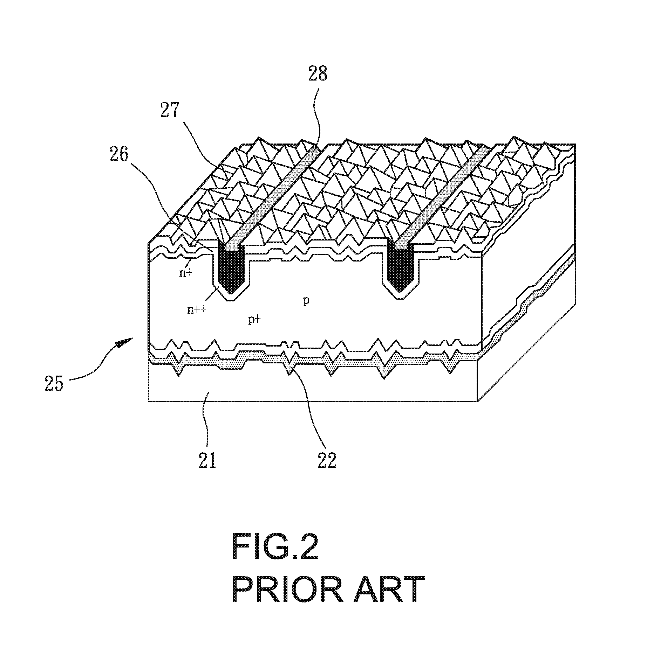

A conventional single-crystal silicon solar cell in accordance with the prior art shown in Fig. 2 comprises a silicon substrate 21 having a surface provided with at least one inner electrode 22, at least one middle reaction layer 25 plated on a surface of the silicon substrate 21, and a transparent electrically conducting layer 26 plated on a surface of the middle reaction layer 25 and having a surface provided with at least one outer electrode 28 which is connected serially with the inner electrode 22 of the silicon substrate 21. The electrically conducting layer 26 has a Photovolatic effect. The surface of the electrically conducting layer 26 is provided with a plurality of pyramidal surfaces 27 to reduce reflection of the sun light. The middle reaction layer 25 includes at least one P+ semi-conductor layer plated on the silicon substrate 21 to produce electric holes, at least one P semi-conductor layer plated on the P+ semi-conductor layer and at least one N+ semi-conductor layer plated on the P semi-conductor layer to produce electrons. Thus, the pyramidal surfaces 27 of the electrically conducting layer 26 can increase the illuminated area of the single-crystal silicon solar cell to enhance the generating efficiency of the single-crystal silicon solar cell.

However, the conventional single-crystal silicon solar cell cannot envelop the sun light completely, and the sun light is reflected by the pyramidal surfaces 27 of the electrically conducting layer 26 to form an energy loss during the reflected process of the sun light, thereby decreasing the generating efficiency of the conventional thin-film solar cell.

BRIEF SUMMARY OF THE INVENTION

In accordance with the present invention, there is provided a thin-film solar cell, comprising an optical conduction cylinder made of a transparent material with a high light permeability, a transparent electrically conducting layer evenly plated on an axially extending peripheral surface of the optical conduction cylinder and having a peripheral wall provided with at least one inner electrode, at least one middle reaction layer plated on a peripheral surface of the electrically conducting layer and having an optical absorbing capacity to excite shifting of electrons and electric holes to produce an electric current, and a reflective layer plated on a peripheral surface of the middle reaction layer to prevent from permeation of a light and having a peripheral wall provided with at least one axially extending outer electrode which corresponds to the inner electrode of the electrically conducting layer.

According to the primary objective of the present invention, the reflective layer can reflect the sun light to prevent the sun light from permeating the reflective layer so that the sun light is enveloped in the optical conduction cylinder completely and is reflected successively in the reflective layer until the solar energy is exhausted such that the thin-film solar cell can absorb the solar energy to the maximum extent so as to enhance the light enveloping effect largely and to enhance the generating efficiency of the thin-film solar cell.

According to another objective of the present invention, the thin-film solar cell has a three-dimensional cylindrical profile by provision of the optical conduction cylinder, so that the illuminated area of the thin-film solar cell is increased to enhance the generating efficiency of the thin-film solar cell.

According to a further objective of the present invention, the area of the thin-film solar cell can be reduced under the same generating efficiency to reduce the volume and storage space of the thin-film solar cell.

Further benefits and advantages of the present invention will become apparent after a careful reading of the detailed description with appropriate reference to the accompanying drawings.

BRIEF DESCRIPTION OF THE SEVERAL VIEWS OF THE DRAWING(S)

Fig. 1 is a perspective view of a conventional thin-film solar cell in accordance with the prior art.

Fig. 2 is a perspective view of a conventional single-crystal silicon solar cell in accordance with the prior art.

Fig. 3 is a perspective view of a thin-film solar cell in accordance with the preferred embodiment of the present invention.

Fig. 4 is a partially cutaway cross-sectional view of the thin-film solar cell as shown in Fig. 3.

Fig. 5 is a side cross-sectional view of the thin-film solar cell as shown in Fig. 3.

Fig. 6 is a schematic planar operational view of the thin-film solar cell as shown in Fig. 3 in use.

Fig. 7 is a perspective view of a thin-film solar cell in accordance with another preferred embodiment of the present invention.

Fig. 8 is a perspective view showing a thin-film solar cell in accordance with the preferred embodiment of the present invention and a conventional thin-film solar cell in accordance with the prior art.

Fig. 9 is a side cross-sectional view of a thin-film solar cell in accordance with another preferred embodiment of the present invention.

Fig. 10 is a side cross-sectional view showing combination of a plurality of thin-film solar cells as shown in Fig. 9.

Fig. 11 is a side cross-sectional view of a thin-film solar cell in accordance with another preferred embodiment of the present invention.

Fig. 12 is a side cross-sectional view showing combination of a plurality of thin-film solar cells as shown in Fig. 11.

DETAILED DESCRIPTION OF THE INVENTION

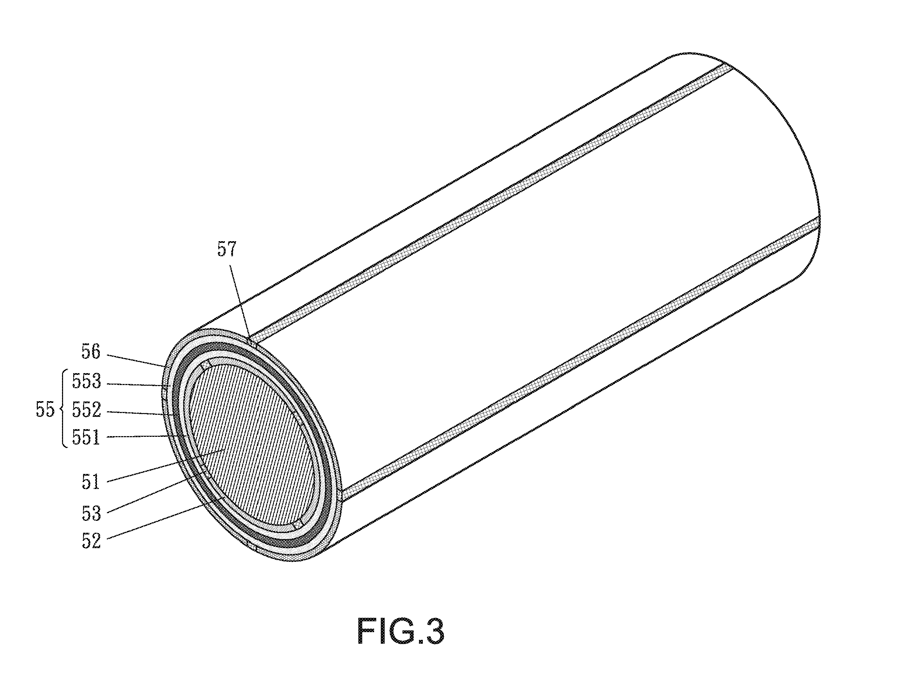

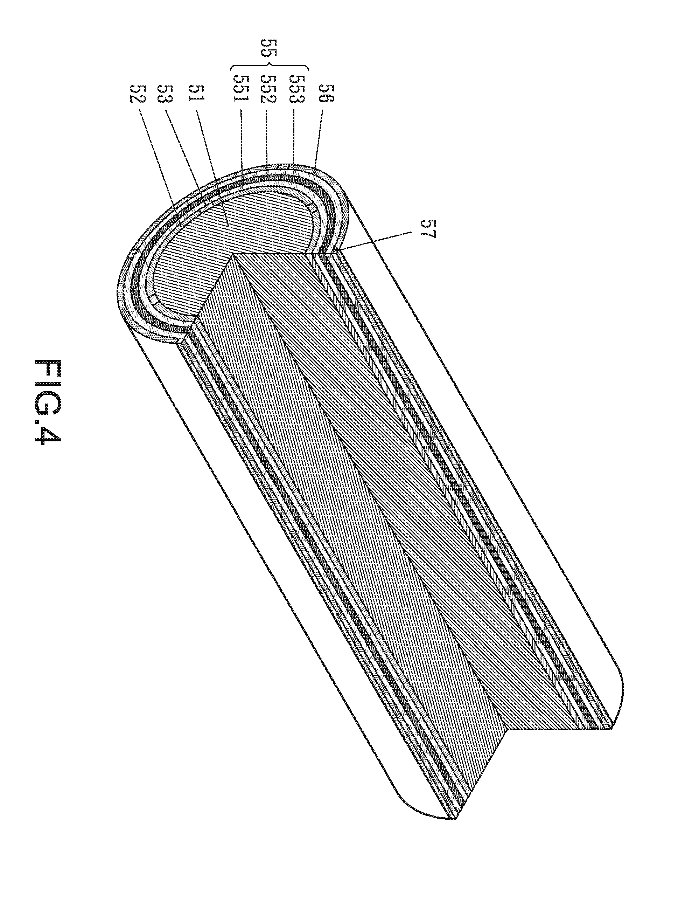

Referring to the drawings and initially to Figs. 1-5, a thin-film solar cell in accordance with the preferred embodiment of the present invention comprises an optical conduction cylinder 51 made of a transparent material with a high light permeability, a transparent electrically conducting layer 52 evenly plated on an axially extending peripheral surface of the optical conduction cylinder 51 and having a peripheral wall provided with at least one inner electrode 53, at least one middle reaction layer 55 plated on a peripheral surface of the electrically conducting layer 52 and having an optical absorbing capacity to excite shifting of electrons and electric holes to produce an electric current, and a reflective layer 56 plated on a peripheral surface of the middle reaction layer 55 to prevent from permeation of a light and having a peripheral wall provided with at least one axially extending outer electrode 57 which corresponds to the inner electrode 53 of the electrically conducting layer 52.

The optical conduction cylinder 51 is a solid or hollow cylinder. In the preferred embodiment of the present invention, the optical conduction cylinder 51 is a solid cylinder. In addition, the optical conduction cylinder 51 is preferably made of an organic or inorganic material. For example, the optical conduction cylinder 51 is made of a flexible optical fiber, glass column, glass tube, quartz or crystal, or a high molecular material with an optical conductive feature. Thus, when the sun light enters the optical conduction cylinder 51, the optical conduction cylinder 51 forms a fully reflective field to envelop the sun light completely so that the sun light is completely enveloped in the optical conduction cylinder 51 and will not permeate the optical conduction cylinder 51.

The peripheral wall of the electrically conducting layer 52 is formed with at least one axially extending groove (not labeled) to receive the inner electrode 53. The axially extending groove of the electrically conducting layer 52 is formed by etching or a laser technology. The inner electrode 53 has a thickness equal to that of the electrically conducting layer 52 and has a bottom face contacting the peripheral surface of the optical conduction cylinder 51.

The middle reaction layer 55 is made of a silicon semi-conductor, a compound semi-conductor or an organic semi-conductor. The middle reaction layer 55 includes at least one P+ semi-conductor layer 551 plated on the electrically conducting layer 52 to produce electric holes, at least one P semi-conductor layer 552 plated on the P+ semi-conductor layer 551 and at least one N+ semi-conductor layer 553 plated on the P semi-conductor layer 552 to produce electrons.

In practice, the middle reaction layer 55 can absorb the sun light independently so that when the P+ semi-conductor layer 551 and the N+ semi-conductor layer 553 of the middle reaction layer 55 are connected, an induction electrode is produced to drive the electrons and electric holes to shift by exciting of the sun light so as to produce a generating function and to enhance the generating efficiency. Thus, the electrons are moved outward to reach the outer electrode 57 of the reflective layer 56 to form an electronic flow in the outer electrode 57 of the reflective layer 56, while the electric holes are moved inward to reach the inner electrode 53 of the electrically conducting layer 52 to form an electric current in the inner electrode 53 of the electrically conducting layer 52 so that the electronic flow is connected to the electric current to form a generating system.

The P+ semi-conductor layer 551 of the middle reaction layer 55 is a P-type silicon mixed with impurities consisting of IIIA chemical elements, such as boron (B), to produce an energy barrier to the electrons and electric holes so that the electrons and electric holes will not combine easily to prevent the electrons and electric holes from disappearing due to combination. The P semi-conductor layer 552 of the middle reaction layer 55 has the maximum thickness to provide the electric holes. The N+ semi-conductor layer 553 of the middle reaction layer 55 is a N-type silicon mixed with impurities consisting of VA chemical elements, such as phosphorus (P) or arsenic (As), to produce an energy barrier to the electrons and electric holes so that the electrons and electric holes will not combine easily to prevent the electrons and electric holes from disappearing due to combination.

The reflective layer 56 is a metallic film made of A1 or Au. The reflective layer 56 can excite electrons during the reflected process of the sun light. The peripheral wall of the reflective layer 56 is formed with at least one axially extending groove (not labeled) to receive the outer electrode 57. The axially extending groove of the reflective layer 56 is formed by etching or a laser technology. The outer electrode 57 of the reflective layer 56 is connected serially with the inner electrode 53 of the electrically conducting layer 52 to conduct the electrical energy.

When in use, the optical conduction cylinder 51 can completely envelope the electrons and electric holes produced in the middle reaction layer 55 when the sun light enters the optical conduction cylinder 51. At this time, the electrons are moved outward to reach the outer electrode 57 of the reflective layer 56 to form an electronic flow in the outer electrode 57 of the reflective layer 56, while the electric holes are moved inward to reach the inner electrode 53 of the electrically conducting layer 52 to form an electric current in the inner electrode 53 of the electrically conducting layer 52 so that the electronic flow is connected to the electric current to form a generating system. Thus, the thin-film solar cell has a better Photovolatic effect and has a larger illuminated area.

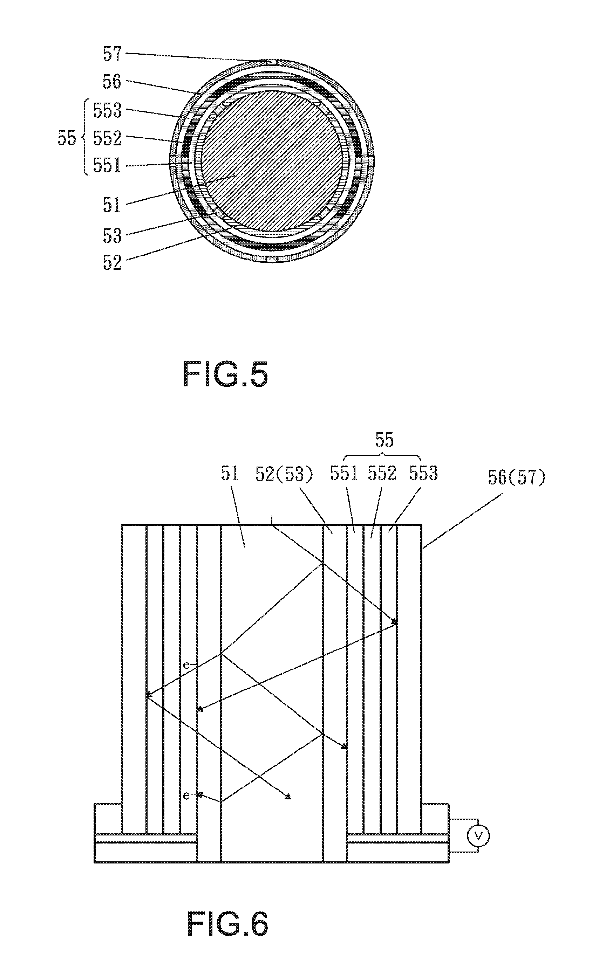

As shown in Figs. 5 and 6, when the sun light enters the optical conduction cylinder 51, the sun light is conducted through the inner electrode 53 of the electrically conducting layer 52 into the middle reaction layer 55. When the sun light passes through the middle reaction layer 55, electrons are produced in the N+ semi-conductor layer 553 of the middle reaction layer 55, and electric holes are produced in the P+ semi-conductor layer 551 of the middle reaction layer 55. At this time, the P+ semi-conductor layer 551 and the N+ semi-conductor layer 553 of the middle reaction layer 55 produce an energy barrier to the electrons and electric holes so that the electrons and electric holes will not combine easily to prevent the electrons and electric holes from disappearing due to combination. In addition, the reflective layer 56 can reflect the sun light to prevent the sun light from permeating the reflective layer 56 and can excite electrons during the reflected process of the sun light. Thus, the electrons can be moved outward to reach the outer electrode 57 of the reflective layer 56 to form an electronic flow in the outer electrode 57 of the reflective layer 56, while the electric holes can be moved inward to reach the inner electrode 53 of the electrically conducting layer 52 to form an electric current in the inner electrode 53 of the electrically conducting layer 52. Finally, the electronic flow is connected to the electric current to form a generating system.

Thus, the thin-film solar cell has a three-dimensional cylindrical profile by provision of the optical conduction cylinder 51, which is different from the planar profile of the conventional thin-film solar cell. In such a manner, the reflective layer 56 can reflect the sun light to prevent the sun light from permeating the reflective layer 56 so that the sun light is enveloped in the optical conduction cylinder 51 completely. Thus, the sun light is reflected successively in the reflective layer 56 of the thin-film solar cell until the solar energy is exhausted so that the thin-film solar cell can absorb the solar energy to the maximum extent to enhance the light enveloping effect largely, to increase the illuminated area of the thin-film solar cell and to further enhance the generating efficiency of the thin-film solar cell.

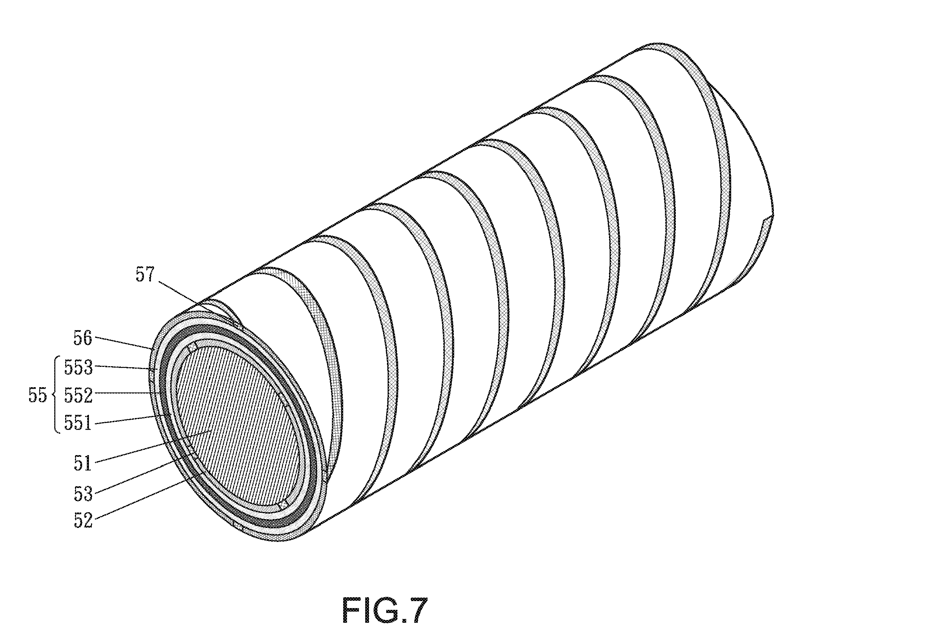

As shown in Fig. 7, the inner electrode 53 of the electrically conducting layer 52 has a helical profile, and the outer electrode 57 of the reflective layer 56 also has a helical profile.

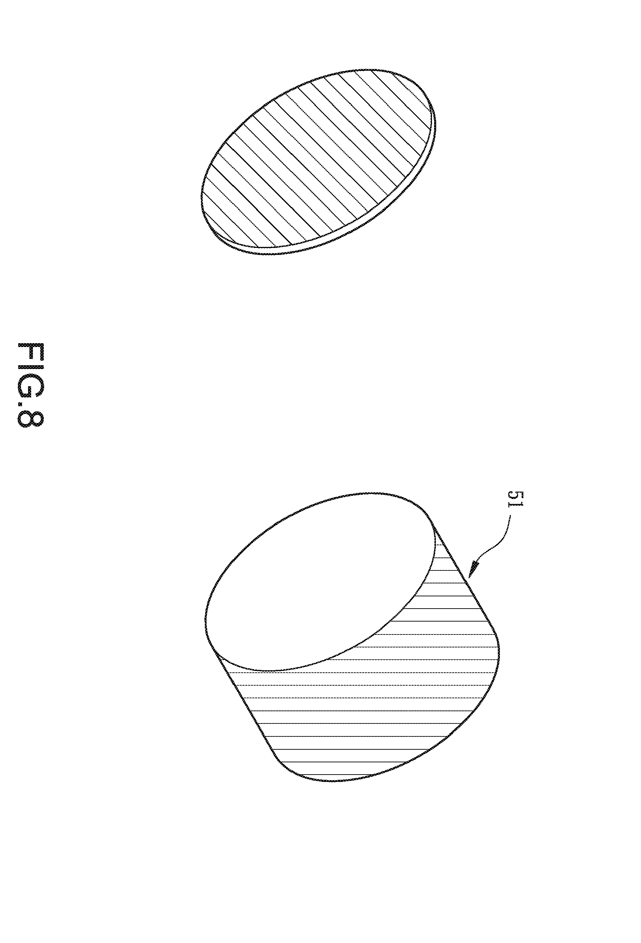

As shown in Fig. 8, the thin-film solar cell of the present invention has a three-dimensional cylindrical structure by provision of the optical conduction cylinder 51, and the conventional thin-film solar cell has a planar structure with a circular plate. The conventional thin-film solar cell has a diameter equal to "a" and an area equal to "A0". The thin-film solar cell of the present invention has a diameter equal to "a", a height equal to "h", and an area equal to "A1". The effective area ratio of A0/A1 is calculated as follows.

$$A0 = \pi R^2 = (a/2)^2 \pi = (a^2/4) \pi$$

$$A1 = (2 \pi R)h = (2a/2) \pi h = a \pi h$$

$$A0/A1 = ((a^2/4) \pi )/(a \pi h) = a/4h$$

Namely, if a = 4h, then h = a/4

The height "h" is defined as a geometric calculation critical height.

Thus, when the height "h" is greater than a/4, the illuminated efficiency (defined as the ratio of the illuminated area of the thin-film solar cell of the present invention and that of the conventional thin-film solar cell) is greater than one. When the diameter "a" of the thin-film solar cell of the present invention is decreased, the illuminated area of the thin-film solar cell of the present invention is increased. Thus, when the conventional thin-film solar cell is changed to the thin-film solar cell of the present invention, the illuminated area is increased largely so that the generating efficiency of the thin-film solar cell is increased. In the preferred embodiment of the present invention, the optical conduction cylinder 51 has a height greater than or equal to the geometric calculation critical height "h" (for example, one quarter of the diameter) of the thin-film solar cell so that the illuminated area of the thin-film solar cell of the present invention is greater than or equal to one (1).

Assuming the thin-film solar cell with a diameter of "a" consists of many (number "n") equivalent thin-film solar cells each having a diameter of "b", the effective sectional area of the equivalent thin-film solar cells is "A2", and the effective area ratio of A2/A1 is calculated as follows.

$$A1 = (2 \pi R)h = (2a/2) \pi h = a \pi h$$

$$A2 = n(2 \pi R)h = n(2b/2) \pi h = nb \pi h$$

$$\lhook\!\! n(b/2)^2 \pi = (a/2)^2 \pi , \quad a = b \surd n$$

$$A2/A1 = nb \pi h / a \pi h = nb/a = nb/(b \surd n) = \surd n$$

The number "n" is a positive integer so that the effective area ratio of A2/A1 is greater than one (1). Thus, when the diameter "a" of the thin-film solar cell of the present invention is decreased, the illuminated area of the thin-film solar cell of the present invention is further increased under the condition of the effective sectional area so that the generating efficiency of the thin-film solar cell is increased. Therefore, the area of the thin-film solar cell of the present invention can be reduced under the same generating efficiency to reduce the volume and storage space of the thin-film solar cell.

In the preferred embodiment of the present invention, the thin-film solar cell may have a symmetrically or non-symmetrically arranged polygonal cross-sectional profile. For example, the optical conduction cylinder 51 has a symmetrically arranged tetragonal, circular or oval cross-sectional profile.

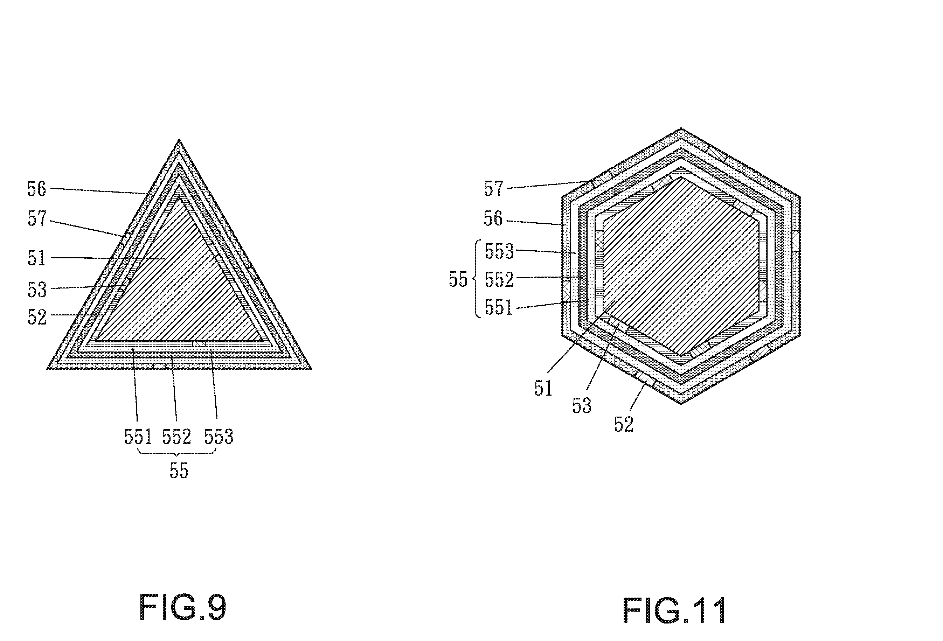

As shown in Fig. 9, the optical conduction cylinder 51 has a symmetrically arranged triangular cross-sectional profile so that the thin-film solar cell also has a symmetrically arranged triangular cross-sectional profile.

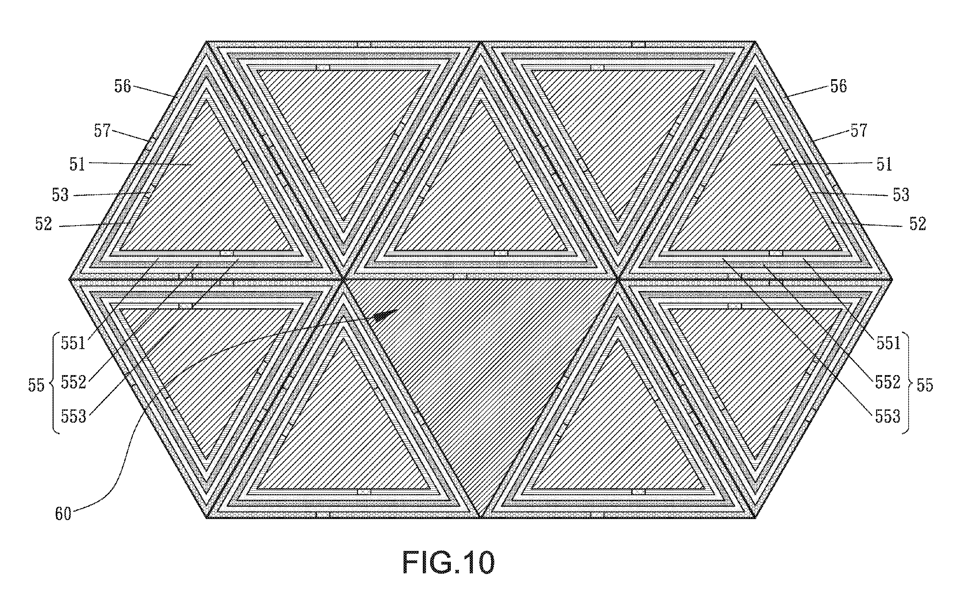

As shown in Fig. 10, a plurality of thin-film solar cells having a symmetrically arranged triangular cross-sectional profile are arranged in a staggered manner to form an array, and at least one heatsink device 60 having a symmetrically arranged triangular cross-sectional profile is located between the thin-film solar cells to provide a heatsinking effect to the thin-film solar cells.

As shown in Fig. 11, the optical conduction cylinder 51 has a symmetrically arranged hexagonal cross-sectional profile so that the thin-film solar cell also has a symmetrically arranged hexagonal cross-sectional profile.

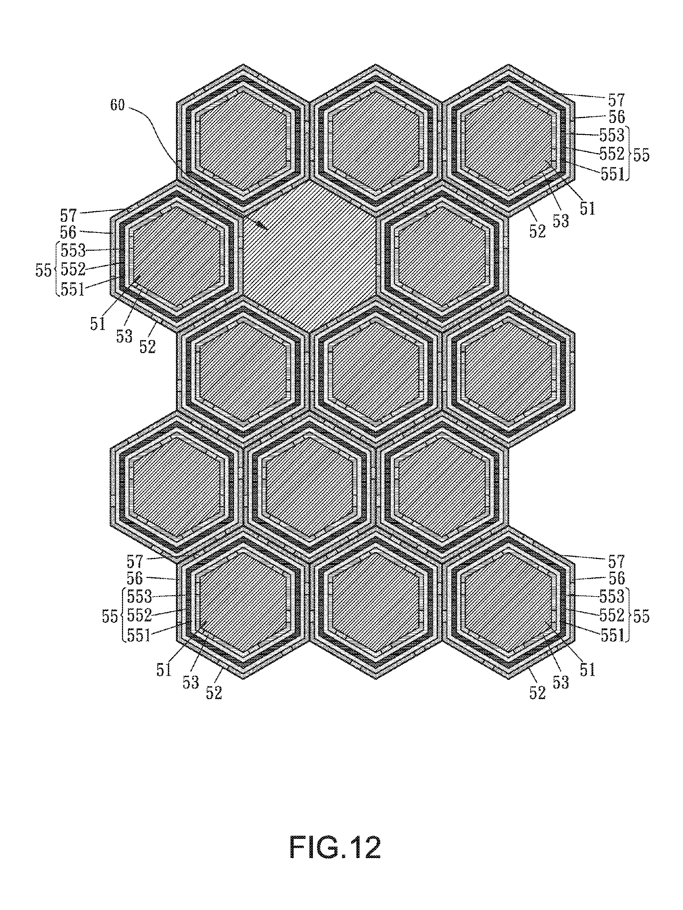

As shown in Fig. 12, a plurality of thin-film solar cells having a symmetrically arranged hexagonal cross-sectional profile are arranged in a staggered manner to form an array, and at least one heatsink device 60 having a symmetrically arranged hexagonal cross-sectional profile is located between the thin-film solar cells to provide a heatsinking effect to the thin-film solar cells.

Accordingly, the reflective layer 56 can reflect the sun light to prevent the sun light from permeating the reflective layer 56 so that the sun light is enveloped in the optical conduction cylinder 51 completely and is reflected successively in the reflective layer 56 until the solar energy is exhausted such that the thin-film solar cell can absorb the solar energy to the maximum extent to enhance the light enveloping effect largely and to enhance the generating efficiency of the thin-film solar cell. In addition, the thin-film solar cell has a three-dimensional cylindrical profile by provision of the optical conduction cylinder 51, so that the illuminated area of the thin-film solar cell is increased to enhance the generating efficiency of the thin-film solar cell. Further, the area of the thin-film solar cell can be reduced under the same generating efficiency to reduce the volume and storage space of the thin-film solar cell.

Although the invention has been explained in relation to its preferred embodiment(s) as mentioned above, it is to be understood that many other possible modifications and variations can be made without departing from the scope of the present invention. It is, therefore, contemplated that the appended claim or claims will cover such modifications and variations that fall within the true scope of the invention.

**Claims**

1. A thin-film solar cell, comprising:

   an optical conduction cylinder made of a transparent material with a high light permeability;
   a transparent electrically conducting layer evenly plated on an axially extending peripheral surface of the optical conduction cylinder and having a peripheral wall provided with at least one inner electrode;
   at least one middle reaction layer plated on a peripheral surface of the electrically conducting layer and having an optical absorbing capacity to excite shifting of electrons and electric holes to produce an electric current; and
   a reflective layer plated on a peripheral surface of the middle reaction layer to prevent from permeation of a light and having a peripheral wall provided with at least one axially extending outer electrode which corresponds to the inner electrode of the electrically conducting layer.

2. The thin-film solar cell of claim 1, wherein the optical conduction cylinder is a solid cylinder.

3. The thin-film solar cell of claim 1, wherein the middle reaction layer is made of a silicon semi-conductor, a compound semi-conductor or an organic semi-conductor.

4. The thin-film solar cell of claim 1, wherein the optical conduction cylinder is made of an organic or inorganic material.

5. The thin-film solar cell of claim 1, wherein the optical conduction cylinder is made of a flexible optical fiber, glass column, glass tube, quartz or crystal, or a high molecular material with an optical conductive feature.

6. The thin-film solar cell of claim 1, wherein the optical conduction cylinder has a height greater than or equal to a geometric calculation critical height of the thin-film solar cell.

7. The thin-film solar cell of claim 1, wherein the optical conduction cylinder has a symmetrically or non-symmetrically arranged polygonal cross-sectional profile.

8. The thin-film solar cell of claim 1, wherein the optical conduction cylinder has a symmetrically arranged triangular cross-sectional profile.

9.  The thin-film solar cell of claim 1, wherein the optical conduction cylinder has a symmetrically arranged tetragonal cross-sectional profile.

10. The thin-film solar cell of claim 1, wherein the optical conduction cylinder has a symmetrically arranged circular or oval cross-sectional profile.

11. The thin-film solar cell of claim 1, wherein the optical conduction cylinder has a symmetrically arranged hexagonal cross-sectional profile.

12. The thin-film solar cell of claim 1, wherein the reflective layer is a metallic film made of Al or Au.

17

16

n+

15 p

p+

12

11

13

FIG.1
PRIOR ART

FIG.2
PRIOR ART

FIG.3

FIG.4

FIG.5

FIG.6

FIG.7

FIG.8

FIG.10

FIG.12

| **INTERNATIONAL SEARCH REPORT** | International application No. |
| --- | --- |
| | PCT/CN2009/070853 |

**A.  CLASSIFICATION OF SUBJECT MATTER**

H01L 31/0352(2006.01)i

According to International Patent Classification (IPC) or to both national classification and IPC

**B.  FIELDS SEARCHED**

Minimum documentation searched (classification system followed by classification symbols)

IPC:H01L/-

Documentation searched other than minimum documentation to the extent that such documents are included in the fields searched

Electronic data base consulted during the international search (name of data base and, where practicable, search terms used)

CNKI,CPRS,EPODOC,WPI: solar cell,thin film,column,transparent,conduct+,reflect,electrode

**C.  DOCUMENTS CONSIDERED TO BE RELEVANT**

| Category* | Citation of document, with indication, where appropriate, of the relevant passages | Relevant to claim No. |
| --- | --- | --- |
| A | US7235736B1(Solyndra,Inc.)26 Jun. 2007（26.06.2007）the whole document | 1-12 |
| A | US2007227579A1(Benyamin Buller etc.)04 Oct. 2007（04.10.2007）the whole document | 1-12 |
| A | US2008264473A1(Brian Cumpston etc.)30 Otc. 2008（30.10.2008）the whole document | 1-12 |

☐ Further documents are listed in the continuation of Box C.      ☒ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim (S) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&"document member of the same patent family |

| Date of the actual completion of the international search | Date of mailing of the international search report |
| --- | --- |
| 15 Dec. 2009（15.12.2009） | **24 Dec. 2009 (24.12.2009)** |
| Name and mailing address of the ISA/CN The State Intellectual Property Office, the P.R.China 6 Xitucheng Rd., Jimen Bridge, Haidian District, Beijing, China 100088 Facsimile No. 86-10-62019451 | Authorized officer Zhi,Yue Telephone No. (86-10)62411788 |

Form PCT/ISA /210 (second sheet) (July 2009)

<div align="center">

**INTERNATIONAL SEARCH REPORT**
Information on patent family members

</div>

| | International application No. |
| --- | --- |
| | PCT/CN2009/070853 |

| Patent Documents referred in the Report | Publication Date | Patent Family | Publication Date |
| --- | --- | --- | --- |
| US7235736B1 | 26.06.2007 | WO2008051275A2 | 02.05.2008 |
| | | EP2002479A2 | 17.12.2008 |
| | | WO2008051275A3 | 12.02.2009 |
| | | KR20080107470A | 10.12.2008 |
| | | DE202007018755U | 04.06.2009 |
| US2007227579A1 | 04.10.2007 | WO2007117442A2 | 18.10.2007 |
| | | WO2007117442A3 | 13.03.2008 |
| | | EP2011159A2 | 07.01.2009 |
| | | CN101454904A | 10.06.2009 |
| US2008264473A1 | 30.10.2008 | WO2008136986A1 | 13.11.2008 |

Form PCT/ISA /210 (patent family annex) (July 2009)